Europäisches Patentamt

European Patent Office

Office européen des brevets

(19)

(11) Publication number: **0 156 312**
A2

(12) **EUROPEAN PATENT APPLICATION**

(21) Application number: **85103314.2**

(22) Date of filing: **21.03.85**

(51) Int. Cl.⁴: **H 01 L 41/18**

(30) Priority: **21.03.84 JP 53837/84**

(43) Date of publication of application:
**02.10.85 Bulletin 85/40**

(84) Designated Contracting States:
**DE FR GB NL**

(71) Applicant: **NGK Spark Plug Co. Ltd.
14-18, Takatsuji-machi Mizuho-ku
J-Nagoya-shi, Aichi-ken(JP)**

(72) Inventor: **Fujimoto, Naoyuki
1-61, Shimigaoka Midori-ku
Nagoya-shi Aichi-ken(JP)**

(72) Inventor: **Sobue, Hideo
3-32-5, Yanagae-cho Mizuho-ku
Nagoya-shi Aichi-ken(JP)**

(74) Representative: **Hrabal, Ulrich, Dr. Dipl.-Chem. et al,
MEISSNER, BOLTE & PARTNER Postfach 86 06 24
D-8000 München 86(DE)**

(54) A piezo-electric ceramic composition for resonator in electrical wave filters.

(57) A new piezo-electric ceramic composition for resonator in electrical wave-filters are now provided, which essentially consists of a modified or unmodified lead zirconate titanate and, as additives, 1.5 to 4.5% of tungsten oxide ($WO_3$) and 0.1 to 0.5% of chromium oxide ($Cr_2O_3$) based on the total weight of the composition, and which shows in combination a low mechanical quality factor ($Qm$) value of not more than 300, a high electromechanical coupling co-efficient, a high dielectric constant, and improved temperature and time stabilities of the resonant frequency for the filter resonator. The wave-filter produced from the new composition exhibits improved group-delay-time characteristics.

EP 0 156 312 A2

0156312

# A PIEZO-ELECTRIC CERAMIC COMPOSITION FOR
## RESONATOR IN ELECTRICAL WAVE FILTERS

SUMMARY OF THE INVENTION:

This invention relates to a new lead zirconate titanate based piezo-electric ceramic composition for producing ceramic resonator in the electrical wave-filters. More particularly, this invention relates to a new piezo-electric ceramic composition comprising a modified or unmodified lead zirconate titanate together with tungsten oxide ($WO_3$) and chromium oxide ($Cr_2O_3$) as additives and well suited for use as the wave-filter resonator exhibiting improved group-delay-time characteristics for the filters.

BACKGROUND OF THE INVENTION:

It is known that a piezo-electric ceramic material comprising lead zirconate titanate of empirical formula $Pb(Zr \cdot Ti)O_3$, a polycrystalline material effectively composed of a solid solution of lead zirconate ($PbZrO_3$) and lead titanate ($PbTiO_3$) has been used in various electromechanical resonators (see, e.g., U.S. Patent No. 2,708,244). It is also known that the electrical and physical properties of the piezo-electric ceramics comprising lead zirconate titanate can be modified by admixing with a proportion of chromium oxide or uranium oxide or another oxides, and/or by replacing a part of the lead component in the lead zirconate titanate by an alkaline earth metal selected from strontium (Sr), calcium (Ca) and barium (Ba) (see, e.g., U.S. Patent Nos. 3,006,857; 3,117,094 and 3,194,765).

In recent years, various ceramic wave-filters such as those of ladder-type filter arrangement have been used in band-pass filter circuits of pocket bell, vehicle telephone and similar devices which utilize the electric wave pulses according to the digital communication system. For these particular applications, it is required to provide such ceramic wave-filters which can give no or little phase distortion in the output signals, and this is accomplished by improving the group-delay-time characteristics of the filters.

This invention has been made for an object to meet such outstanding requirement. In an attempt to achieve the object of this invention, we, the present inventors, have made researches with noticing the facts that the group-delay-time characteristics of the ceramic wave-filters greatly depends on the value of the mechanical quality factor (usually abbreviated as Qm) of the ceramic resonator provided in said wave-filters, and that the much more the Qm value of the resonator decreases, the curve of showing the group-delay-time characteristics of the wave-filter (namely, the curve of the values of the group-delay-time plotted against the wave frequencies as measured with said wave-filter) becomes much more flat and hence the phase distortion of the output signals emitted from the filter decreases much more. As a result, we have succeeded in obtaining a new piezo-electric ceramic composition which is particularly capable of exhibiting a

- 3 -

decreased Qm value of not more than 300.

Thus, through our researches, we have now found that the piezo-electric ceramic material consisting essentially of electrostatically prepolarized lead zirconate titanate can be modified so as to improve the group-delay-time characteristics of the filter as produced therefrom, by admixing the ceramic material with an amount of 1.5 to 4.5% by weight of tungsten oxide ($WO_3$) as well as an amount of 0.1 to 0.5% by weight of chromic oxide ($Cr_2O_3$) based on the total weight of the resultant mixture. More particularly, it has been found that when the piezo-electric ceramic material comprising lead zirconate titanate is admixed with an amount of 1.5 to 4.5% by weight of tungsten oxide the mechanical quality factor (Qm) of said ceramic material is advantageously decreased while the electro-mechanical coupling coefficient (hereinafter abbreviated as Kr) and the di-electric constant (hereinafter abbreviated as $\varepsilon$) of said ceramic material are advantageously increased due to the addition of tungsten oxide, although this addition of tungsten oxide can deteriorate much or less the temperature and time stabilities of the resonant frequency (hereinafter abbreviated as Fr) of the resonator produced from the ceramic material. It has also been found that when the piezo-electric ceramic material comprising the lead zirconate titanate as the principal ingredient and the tungsten oxide as the additive ingredient is further admixed with an amount of 0.1 to 0.5% by weight of chromic oxide ($Cr_2O_3$), such decrease in the temperature and time stabilities of the resonant frequency (Fr) of the resonator made of said ceramic material which has invoked due to the addition of tungsten oxide can be reduced or minimized by the addition of chromic oxide, although the addition of this second additive ingredient, chromic oxide in an excessive amount is likely to adversely decrease the Kr value and increase the Qm value of the material. In consequence, we have now found that the combined addition of proper proportions of tungsten oxide and chromic oxide to the piezo-electric ceramic material essentially consisting of lead zirconate titanate are effective to give improved group-delay-time characteristics for the filter comprising the resonator made from said ceramic material. Furthermore, we have now found that the aforesaid advantageous effects of the combined addition of proper proportions of tungsten oxide and chromic oxide are equally obtainable with such piezo-electric ceramic materials comprising a lead zirconate titanate which has been so modified in a known manner that a part of not more than 10 molar % of the lead component, namely zero to 10 molar % of the lead (Pb) component in the lead zirconate titanate is replaced by one or more of alkaline earth metals selected from strontium, calcium and barium with a view to enhance the sintering property of ceramics. Besides, we have found that the meritable effects of the tungsten oxide and chromic oxide added are obtainable also when the chemical composition of the lead zirconate titanate is so further modified in a known manner that the atomic ratio of Zr to Ti in the lead zirconate titanate is changed from a value of 0.5:0.5 (for $Pb(Zr_{0.5} \cdot Ti_{0.5})O_3$, namely the solid solution of equi-molar proportions of lead zirconate $PbZrO_3$ and lead titanate $PbTiO_3$) to a value of ranging from 0.48:0.52 to 0.52:0.48. Thus, when the chemical composition of a lead zirconate titanate is expressed by an empirical formula $Pb(Zr_a \cdot Ti_{1-a})O_3$, the lead zirconate titanates effectively available for the purposes of this invention include such one of the formula $Pb(Zr_a \cdot Ti_{1-a})O_3$ wherein the value of $\underline{a}$ is ranging from 0.48 to 0.52 and which is able to provide a lead zirconate titanate of such chemical composition in which the crystal phase change (usually called the morphotropic transformation) can occur with exhibiting a very much enhanced piezo-electric electric distortion effect but with giving only a low value of not more than 0.20% for the temperature coefficient of the resonant frequency (in a temperature range of -20°C to 60°C).

DETAILED DESCRIPTION OF THE INVENTION:

According to a first aspect of this invention, therefore, there is provided a piezo-electric ceramic composition for producing resonators in wave-filters, which comprises as the principal ingredient a lead zirconate titanate of empirical formula $Pb(Zr_a \cdot Ti_{1-a})O_3$ wherein not more than 10 molar % of the Pb component is replaced by an equivalent quantity of at least one alkaline earth metal selected from strontium, calcium and barium and $\underline{a}$ is a value of 0.48 to 0.52, and as the additive ingredients 1.5 to 4.5% by weight of tungsten oxide ($WO_3$) and 0.1 to 0.5% by weight of chromic oxide ($Cr_2O_3$) based on the total weight of the composition.

Accordingly, the piezo-electric ceramic composition of this invention essentially consists of a mixture of the principal lead zirconate titanate ingredient with tungsten oxide ($WO_3$) and chromic oxide ($Cr_2O_3$) as the additive ingredients. The first additive, tungsten oxide ($WO_3$) is effective not only to decrease the mechanical quality factor (Qm) of the ceramic material but also to increase the electromechanical coupling coefficient (Kr) and the di-electric constant ($\varepsilon$) of the ceramic material. When the amount or proportion of tungsten oxide added is less than 1.5% by weight based on the total weight of the material composition, the electric and physical properties of the resulting piezo-electric ceramic material do not reach the satisfactory levels (which are desirable to show an $\varepsilon$ value of not less than 1300, a Kr value of not less than 50%, and a Qm value of not more than 300). The addition of tungsten oxide in excess over the upper limit of 4.5% by weight cannot bring about any further improvement in the desired properties of the resulting piezo-electric ceramic material but conversely can deteriorate the temperature and time stabilities for the resonant frequency (Fr) of the resonator formed of the resulting pieze-electric ceramic material, and thus can increase the change in the resonant frequency (Fr) with temperature and with time, rendering the resonant frequency stability unsatisfactory (to be less than a desired level that the rate of change or variation of Fr with time should be at most 0.10%). While, the second additive, chromic oxide ($Cr_2O_3$) is effective to reduce the change in the resonant frequency (Fr) with temperature and with time, and hence to enhance the temperature and time stabilities for the resonant frequency (Fr). This advantageous effect of chromic oxide can be developed already by addition of a small amount, 0.1% by weight of chromic oxide, but addition of a further increased amount of chromic oxide is likely to result in a reduction in the Kr value and an increase in the Qm value of the resulting piezo-electric ceramic material. For these reasons, the upper limit for the amount of chromic oxide added is necessary to be set at the value of 0.5% by weight of chromic oxide ($Cr_2O_3$) based on the total weight of the ceramic composition of this invention.

In the ceramic composition of this invention, a part of up to 10 molar % of the lead (Pb) component of the lead zirconate titanate can be replaced by an equivalent quantity of at least one of strontium, calcium and barium, as be known in the art, e.g. as disclosed in U.S. Patent No. 3,006,857, with a view to improve the sintering properties of the resulting ceramic material but without deteriorating unduly the di-electric constant and the electromechanical coupling coefficient of the ceramic material. Replacement of a part of more than 10 molar % of the lead component by the alkaline-earth metals could deteriorate the electric and electromechanical properties of the ceramic material.

Furthermore, the reason why the value of $\underline{a}$ should be in the range of 0.48 to 0.52 for the principle ingredient, lead zirconate titanate of empirical formula $Pb(Zr_a \cdot Ti_{1-a})O_3$ present in the ceramic composition of this invention is that the lead zirconate titanates having the values of $\underline{a}$ in the stipulated range are of the formulation which is near the morphotropic phase boundary (see U.S. Patent Nos. 2,708,244 and 3,006,857, for example) and which is able to provide practically utilizable piezo-electric filter resonator material in which the electromechanical coupling coefficient (Kr) and the di-electric constant ($\varepsilon$) have reached maximum and the temperature coefficient of the resonant frequency (in the temperature range of -20 to 60°C) is suppressed to a value of less than 0.2% as desired.

The ceramic composition according to this invention may be prepared in accordance with different ceramic procedures which are well known in the art and are described, for example, in the specification of U.S. Patent Nos. 3,006,857 and 3,194,765. Thus, a preferred method of preparing the ceramic composition comprises mixing lead oxide (PbO), zirconia oxide ($ZrO_2$) and titania ($TiO_2$) each of a chemical pure grade with each other, optionally together with appropriate amounts of strontium, calcium or barium carbonate when a part of the lead component in the lead zirconate titanate product is to be replaced by the alkaline earth metal, so that a mixture of the combined ingredients is obtained. This mixture is then wet or dry milled to achieve thorough mixing and comparatively uniform particle size of the ingredient particles. After this first milling, the mixture is dried (when wet milled) and reground to make the mixture homogeneous as much as possible. The reground mixture is then sintered for reaction to produce the modified or unmodified lead zirconate titanate. The sintered material is then again ground and milled. At this stage, pre-determined suitable proportions of tungsten oxide ($WO_3$) and chromic oxide ($Cr_2O_3$) are thoroughly admixed. After the addition of tungsten oxide and chromic oxide, the mixture obtained is pre-reacted by calcining or sintering at a high temperature for a suitable time. The pre-reacted material is then cooled and crushed and milled to an average particle size of e.g., 1 microns or more or less, followed by being hot-pressed into desired shapes in accordance with conventional ceramic procedures. The shapes so formed are then ultimately fired until the material gains the ceramic quality or maturity. The fired shapes may then be cooled and polarized in a manner well known in the art, for example, by applying a pair of electrodes to opposite sides of the ceramic bodies and applying an electrostatic field to the electrodes so that the ceramic material of the shapes is electrostatically polarized, to exhibit the piezo-electric properties.

This invention is now illustrated with reference to some exemplar ceramic compositions prepared wherein the principal ingredient, lead zirconate titanate present therein is such a modified lead zirconate titanate in which 5 mol.% of the lead component of a pure lead zirconate titanate $(Pb(Zr \cdot Ti)O_3)$ has been replaced by strontium and the ratio of Zr to Ti is equi-molar, and thus of an empirical formula $Pb_{0.95}Sr_{0.05}(Zr_{0.5} \cdot Ti_{0.5})O_3$ and wherein tungsten oxide and chromic oxide have been admixed in the particular proportions indicated in Table 1 given hereinafter.

The formulation of the ceramic sample compositions so prepared is thus represented by the following formula:-

$$Pb_{0.95}Sr_{0.05}(Zr_{0.5} \cdot Ti_{0.5})O_3 + X\ WO_3 + Y\ Cr_2O_3$$

where X denotes the proportion of tungsten oxide in % by weight and Y denotes the proportion of chromic oxide in % by weight as indicated in Table 1 on the weight basis of the whole mixture of all the ingredients. The ceramic samples to be tested were prepared by the following procedure:- All the finely divided ingredient materials, namely the strontium-modified lead zirconate titanate, tungsten oxide and chromic oxide were weighed and mixed together in such proportions that the formulations of the resulting mixtures were corresponding to the respective values of X and Y as indicated in Table 1. The mixture was milled in ball mill, dried and thereafter once pre-calcined at 730-780°C. The pre-calcined material was wet reground in ball mill for 16 hours and dried. The so dried powder was hot-pressed into discs of 20 mm diameter and 1 mm thickness. The discs were sintered at 1100-1200°C for 2 hours so that the whole material of the discs gained the ceramic quality or maturity. The sintered discs were polished at the front and rear sides thereof to give the precisely planar surfaces to which were then bonded two electrodes of silver metal by soldering. The disc material was then polarized by applying a D.C. voltage of 30 to 50 KV/cm for 30 minutes while the discs were kept in a bath of insulation oil. The discs so polarized and showing a conventional electromechanical resonator construction were used as the test samples and tested for measurement of their electric and electromechanical properties. The test results obtained are shown in the following Table 1.

The measurement of di-electric constant ($\varepsilon$) shown in Table 1 was made at a frequency of 1 KHz, and the measurements of the electromechanical coupling coefficient (Kr) and the mechanical quality factor (Qm) were conducted according to the method of standard circuit of I.R.E. (The Institute of Radio Engineers). Besides, the measurement of the rate (in percent) of change in the resonant frequency (Fr) with time was conducted by estimating the change in the central frequency (455 KHz) which occurred in 10,000 hours of service after the polarization, with using the specimen plates of 4.8 mm square which were cut out of the aforesaid sintered discs.

Table 1

| Sample No. | Proportions (% by wt.) of the additive tungsten oxide + chromic oxide | | ε | Kr (%) | Qm | Rate (%) of change in Fr with time |
|---|---|---|---|---|---|---|
| | X | Y | | | | |
| * 1 | 0 | 0.1 | 1120 | 45 | 380 | Less than 0.10 |
| * 2 | 1.0 | 0 | 1290 | 48 | 190 | More than 0.10 |
| * 3 | " | 0.1 | 1260 | 48 | 230 | Less than 0.10 |
| * 4 | " | 0.2 | 1300 | 47 | 270 | " |
| * 5 | " | 0.3 | 1280 | 44 | 350 | " |
| * 6 | " | 0.5 | 1060 | 42 | 490 | " |
| * 7 | " | 0.6 | 980 | 41 | 510 | " |
| * 8 | 1.5 | 0 | 1320 | 52 | 140 | More than 0.10 |
| 9 | " | 0.1 | 1340 | 51 | 190 | Less than 0.10 |
| 10 | " | 0.2 | 1350 | 52 | 190 | " |
| 11 | " | 0.3 | 1420 | 52 | 230 | " |
| 12 | " | 0.5 | 1360 | 50 | 300 | " |
| * 13 | " | 0.6 | 1300 | 49 | 330 | " |
| 14 | 3.0 | 0.1 | 1470 | 56 | 90 | " |
| 15 | " | 0.2 | 1540 | 58 | 140 | " |
| 16 | " | 0.3 | 1600 | 57 | 150 | " |
| 17 | " | 0.5 | 1450 | 53 | 190 | " |
| * 18 | " | 0.6 | 1280 | 50 | 270 | " |
| 19 | 4.5 | 0.1 | 1590 | 58 | 100 | " |
| 20 | " | 0.2 | 1530 | 58 | 90 | " |
| 21 | " | 0.3 | 1570 | 57 | 130 | " |
| 22 | " | 0.5 | 1490 | 52 | 150 | " |
| * 23 | " | 0.6 | 1300 | 49 | 220 | " |
| * 24 | 5.0 | 0.1 | 1730 | 58 | 90 | More than 0.10 |
| * 25 | " | 0.2 | 1690 | 59 | 110 | " |
| * 26 | " | 0.3 | 1600 | 57 | 140 | " |
| * 27 | " | 0.5 | 1540 | 57 | 120 | " |
| * 28 | " | 0.6 | 1500 | 55 | 190 | " |

The asterisk (*) marks denote that the samples tested were "comparative", that is to say, of the formulations going beyond the ranges stipulated according to this invention.

Same tests were conducted with further piezo-electric ceramic material samples which were prepared in the same manner as above and of which the formulation is represented by the following formula:-

$$Pb_{1-z}Sr_z(Zr_{0.5} \cdot Ti_{0.5})O_3 + X\ WO_3 + Y\ Cr_2O_3$$

where $z$ is a value of from zero to 0.10 as indicated in Table 2 below, X denotes the proportion of tungsten oxide in % by weight and Y denotes the proportion of chromic oxide in % by weight as indicated in Table 2, on the weight basis of the whole mixture of all the ingredients. The test results of measurement obtained are summarized in Table 2 below.

### Table 2

| Sample No. | Value of z in the modified lead zirconate titanate used | Proportions (% by wt.) of the additive tungsten oxide + chromic oxide | | $\varepsilon$ | Kr(%) | Qm | Rate(%) of change in Fr with time |
|---|---|---|---|---|---|---|---|
| | | X | Y | | | | |
| 29 | 0 | 3.0 | 0.3 | 1530 | 50 | 290 | Less than 0.10 |
| 30 | 0.03 | 3.0 | 0.3 | 1670 | 56 | 220 | " |
| 31 | 0.07 | 3.0 | 0.3 | 1640 | 51 | 180 | " |
| 32 | 0.10 | 3.0 | 0.3 | 1480 | 50 | 300 | 0.08 |

Besides, test results similar to those of Tables 1 and 2 were obtained when testing in the same manner as above some additional piezo-ceramic material samples having the same formulations as mentioned above except that the strontium component in the modified lead zirconate titanate was replaced by calcium or barium.

Through a series of the tests conducted, we have found that it is difficult to provide such piezo-electric ceramic materials of this invention which exhibit a Kr value of not less than 50% and a Qm value of not more than 300 in combination, unless the ceramic materials essentially exhibit a high di-electric constant ($\varepsilon$) value of not less than 1300.

Accordingly, it is preferred that the piezo-electric ceramic composition of this invention should exhibit a di-electric constant ($\varepsilon$) of not less than 1300, an electromechanical coupling coefficient (Kr) of not less than 50% and a mechanical quality factor (Qm) of not more than 300 in combination.

To demonstrate the excellent electromechanical performances of the resonators made from the piezo-electric ceramic compositions of this invention, the following experiments were made:-

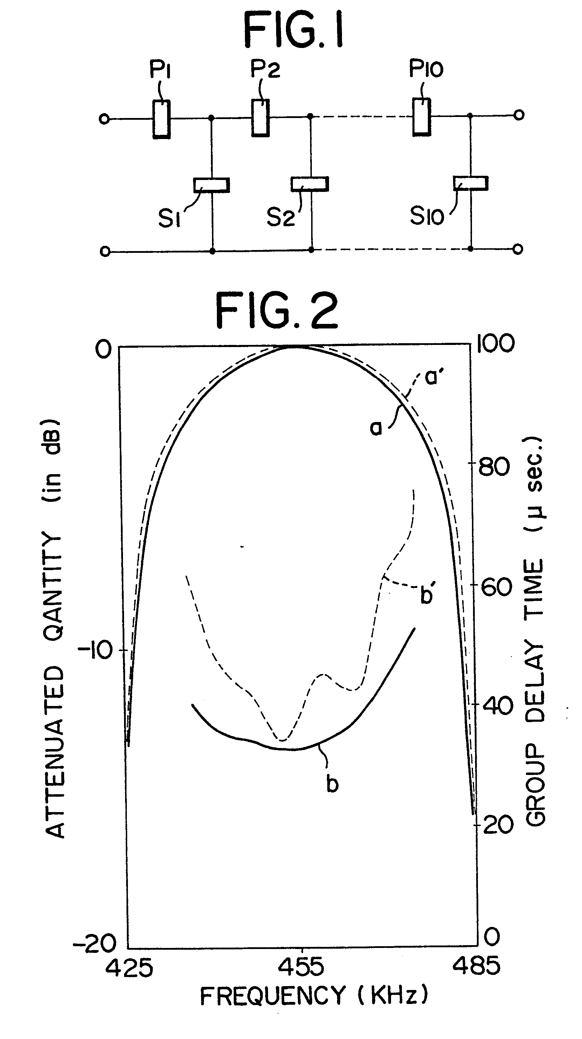

Thus, there was constructed a filter circuit of a known ladder type arrangement as diagrammatically shown in Figure 1 of the accompanying drawings and containing totally 20 filter resonators of a conventional structure but made from a piezo-electric ceramic composition in accordance with this invention, wherein 10 resonators ($P_1$, $P_2 \ldots P_{10}$) were provided in series and 10 resonators ($S_1$, $S_2 \ldots S_{10}$)

were provided in parallel as shown, each resonator (P) in series comprising a square plate-shaped resonator element which was made of the piezo-electric ceramic material of Sample No. 16 set out in Table 1 above ( $\epsilon$ = 1600, Kr = 57%, Qm = 150 in accordance with this invention), had external dimensions of 4.8 mm square and 1.25 mm thickness and exhibited a central frequency of 455 KHz and an electrostatic capacity of 100 to 200 pF, and each resonator (S) in parallel comprising a square plate-shaped resonator element which was similarly made of the piezo-electric ceramic material of Sample No. 16 set out in Table 1, had external dimensions of 4.8 mm square and 0.35 mm thickness and exhibited a central frequency of 455 KHz and an electrostatic capacity of 800 to 1000 pF.

For comparison purpose, there was also constructed a second filter circuit of a known ladder type arrangement equally as shown in Figure 1 and containing totally 20 filter resonators of the conventional structure but made from a piezo-electric ceramic composition not in accordance with this invention, wherein 10 resonators were provided in series and 10 resonators provided in parallel as shown, with the resonator element in each of said resonators being fabricated in the same way as the corresponding resonator element of the first filter circuit mentioned just above but made of the piezo-electric ceramic material of Sample No. 6 set out in Table 1 ($\varepsilon$ = 1060, Kr = 42%, Qm = 490, not in accordance with this invention). With these two filter circuits, the attenuation characteristics and the group-delay-time characteristics of the filter were measured according to a conventional method known in the art. The results of the measurements are graphically represented in Figure 2 of the accompanying drawings.

Referring to the accompanying drawings:-

Figure 1 shows a diagram briefly showing a filter circuit of a known ladder type arrangement and containing the resonators each of a conventional structure but made from the piezo-electric ceramic composition in accordance with this invention, or the resonators each of a conventonal structure and made from the piezo-electric ceramic composition not in accordance with this invention.

Figure 2 shows a graph representing the curves of the attenuation characteristics and the curves of the group-delay-time characteristics of the filter as measured with the filter resonators made from the ceramic composition having a low Qm value in accordance with this invention, and with the filter resonators ("comparative") made from the ceramic composition having a higher Qm value not in accordance with this invention, the resonators being provided in the filter circuit of Figure 1.

In Figure 2, the full-lined curves (a) and (b) of representing the attenuation characteristics and the

0156312

group-delay-time characteristics, respectively, show those for the filter comprising the resonator in accordance with this invention, while the broken-lined cuves (a') and (b') show those for the comparative, filter comprising the resonator not in accordance with this invention. From the curves (b) and (b') of the group-delay-time characteristics shown, it is evident that the less the Qm value of the ceramic material of the filter resonator is, the much more flat is the curve of the group-delay-time characteristics of the filter, with the phase distortion of the output signals becoming less. It may be added, however, that the Qm value may desirably be in a range of 80 to 300 because of that the flatness of the curve of the group-delay-time characteristics is much enhanced as the Qm value decreases, provided that the insertion loss of the resonator can be increased unduly and the selective filtering characteristics of the filter can be deteriorated if the Qm value is lowered excessively.

As will be clear from the results of Tables 1 and 2 hereinbefore and the graph of Figure 2, it is further demonstrated that the piezo-electric ceramic compositions consisting essentially of a modified or unmodified lead zirconate titanate admixed simultaneously with 1.5-4.5% by weight of tungsten oxide and 0.1-0.5% by weight of chromic oxide according to this invention exhibit the desired values in terms of the di-electric constant ($\varepsilon$)

of not less than 1300, electromechanical coupling co-efficient (Kr) of not less than 50% and mechanical quality factor (Qm) of not more than 300 (see Tables 1 and 2); and also exhibit a low rate of change in the resonant frequency with time of not more than 0.10% (see Tables 1 and 2) as well as a favorable flattness in respect of the group-delay-time characteristics curve for the filter, with a lesser phase distortion of the output signals (see Figure 2 of the accompanying drawings).

From the foregoing descriptions, it will be clear that the piezo-electric ceramic composition of this invention shows in practice important advantages that this composition gives greatly improved group-delay-time characteristics for the filter and displays high electric and electromechanical performances with reasonable stability even after long time service.

With reference to the examplar compositions of Table 1 given hereinbefore, there is provided according to a particular embodiment of the first aspect of this invention a piezo-electric ceramic composition for use as ceramic resonator in electrical wave filters, which comprises as the principal ingredient a strontium-modified lead zirconate titanate of empirical formula

$$Pb_{0.95}Sr_{0.05}(Zr_a \cdot Ti_{1-a})O_3$$

wherein $a$ is a value of 0.48 to 0.52, preferably a value of 0.5, and as the additive ingredients 1.5 to 4.5% by weight of tungsten oxide ($WO_3$) and 0.1 to 0.5% by weight of chromic oxide ($Cr_2O_3$) based on the total weight of the composition.

According to a further embodiment of the first aspect of this invention, there is provided a piezo-electric ceramic composition consisting essentially of a strontium-modified lead zirconate titanate of empirical formula

$$Pb_{0.95}Sr_{0.05}(Zr_{0.5} \cdot Ti_{0.5})O_3$$

admixed with 1.5 to 4.5% by weight of tungsten oxide ($WO_3$) and 0.1 to 0.5% by weight of chromic oxide ($Cr_2O_3$) based on the total weight of the composition.

According to another aspect of this invention, there is provided a wave-filter resonator formed from a piezo-electric ceramic material consisting essentially of a strontium-modified lead zirconate titanate of empirical formula

$$Pb_{0.95}Sr_{0.05}(Zr_a \cdot Ti_{1-a})O_3$$

wherein $a$ is a value of 0.48 to 0.52, preferably a value of 0.5, admixed with 1.5 to 4.5% by weight of tungsten oxide ($WO_3$) and 0.1 to 0.5% by weight of chromic oxide ($Cr_2O_3$) based on the total weight of the composition.

What we claim is:

1.  A piezo-electric ceramic composition for producing resonators in wave-filters, which comprises as the principal ingredient a lead zirconate titanate of empirical formula

$$Pb(Zr_a \cdot Ti_{1-a})O_3$$

wherein not more than 10 molar % of the Pb component is replaced by an equivalent quantity of at least one alkaline earth metal selected from strontium, calcium and barium and $\underline{a}$ is a value of 0.48 to 0.52; and as the additive ingredients 1.5 to 4.5% by weight of tungsten oxide ($WO_3$) and 0.1 to 0.5% by weight of chromic oxide ($Cr_2O_3$) based on the total weight of the composition.

2.  A piezo-electric ceramic composition of Claim 1, which comprises as the principal ingredient a strontium-modified lead zirconate titanate of empirical formula

$$Pb_{0.95}Sr_{0.05}(Zr_a \cdot Ti_{1-a})O_3$$

wherein $\underline{a}$ is a value of 0.48 to 0.52.

3.  A piezo-electric ceramic composition of Claim 1, which comprises as the principal ingredient a strontium-modified lead zirconate titanate of empirical formula

$$Pb_{0.95}Sr_{0.05}(Zr_{0.5} \cdot Ti_{0.5})O_3$$

admixed with 1.5 to 4.5% by weight of tungsten oxide ($WO_3$) and 0.1 to 0.5% by weight of chromic oxide ($Cr_2O_3$) based on the total weight of the composition.

4.     A wave-filter resonator formed from a piezo-electric ceramic material consisting essentially of a strontium-modified lead zirconate titanate of empirical formula

$$Pb_{0.95}Sr_{0.05}(Zr_a \cdot Ti_{1-a})O_3$$

wherein $\underline{a}$ is a value of 0.48 to 0.52, admixed with 1.5 to 4.5% by weight of tungsten oxide ($WO_3$) and 0.1 to 0.5% by weight of chromic oxide ($Cr_2O_3$) based on the total weight of the composition.

0156312

# FIG.1

# FIG.2